(19)

**Europäisches Patentamt**
**European Patent Office**
**Office européen des brevets**

(11) **EP 2 483 605 B1**

(12) **EUROPÄISCHE PATENTSCHRIFT**

(45) Veröffentlichungstag und Bekanntmachung des Hinweises auf die Patenterteilung:
**25.01.2017 Patentblatt 2017/04**

(21) Anmeldenummer: **10784678.4**

(22) Anmeldetag: **24.09.2010**

(51) Int Cl.:
*F24F 11/00* *(2006.01)*      *H05K 7/20* *(2006.01)*

(86) Internationale Anmeldenummer:
**PCT/DE2010/075095**

(87) Internationale Veröffentlichungsnummer:
**WO 2011/038732 (07.04.2011 Gazette 2011/14)**

(54) **REGELUNGSVERFAHREN UND KLIMATISIERUNGSSYSTEM**

CONTROL METHOD AND CLIMATE CONTROL SYSTEM

PROCÉDÉ DE RÉGULATION ET SYSTÈME DE CLIMATISATION

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **30.09.2009 DE 102009044137**

(43) Veröffentlichungstag der Anmeldung:
**08.08.2012 Patentblatt 2012/32**

(73) Patentinhaber: **Correct Power Institute GmbH 34431 Marsberg (DE)**

(72) Erfinder: **STEINKÜHLER, Bernd 32049 Herford (DE)**

(74) Vertreter: **Bakhtyari, Arash Adares Patent- und Rechtsanwälte Reininger & Partner Schumannstraße 2 10117 Berlin (DE)**

(56) Entgegenhaltungen:
**EP-A2- 0 741 269        EP-A2- 1 919 271**
**WO-A1-2008/127344    JP-A- 2003 116 219**
**US-A1- 2006 168 975**

**Beschreibung**

Die Erfindung betrifft ein Regelungsverfahren und ein Klimatisierungssystem. Für eine optimale Funktionsweise von Elektronikbaugruppen ist eine effektive Kühlung von großer Bedeutung. Insbesondere für die Kühlung von Informationstechnologie-Komponenten (IT-Komponenten) in Rechenzentren werden effiziente Klimatisierungssysteme gebraucht, die mit dem Einsatz möglichst geringer Energie für eine optimale Kühlung sorgen. Üblicherweise umfasst das gesamte Klimatisierungssystem in einem Rechenzentrum beziehungsweise in einem Rechnerraum, in dem die Elektronikbaugruppen aufgebaut sind, eine Reihe von Klimatisierungsgeräten.

Diese Klimatisierungsgeräte bilden mehrere Klimatisierungskreisläufe, die parallel zueinander aufgebaut sind und gegebenenfalls miteinander Vernetzt sein können. Ein Klimatisierungskreislauf umfasst beispielsweise eine Kühlwasser liefernde Kältemaschine (auch oft als Chiller bezeichnet) als Kälteerzeuger und ein Umluftkühlgerät (ULK), welches das vom Kälteerzeuger bereitgestellte Kühlwasser zur Erzeugung einer Kaltluft benutzt, den er in einen Kaltgang einleitet. Entlang des Kaltganges sind die Elektronikbaugruppen oder andere Verbraucher angeordnet. Die Verbraucher weisen selbst ebenfalls Verbraucherkühlgeräte auf, welche die Kaltluft aus dem Kaltgang verwenden, um jeweils den Verbraucher auf eine optimale Arbeitstemperatur zu halten. Jedes dieser Klimatisierungsgeräte, also Kälteerzeuger, Umluftkühlgeräte und Verbraucherkühlgeräte weisen in der Regel eigene Regelungsvorrichtungen mit eigenen Regelalgorithmen auf, welche jeweils die effiziente Regelung des jeweiligen Klimatisierungsgerätes sicherstellen sollen. Mit anderen Worten: Jedes Klimatisierungsgerät wird in einem individuell optimierten Arbeitspunkt betrieben. Dies kann jedoch zu einem sehr hohen Energieverbrauch führen, da der Betrieb eines Klimatisierungsgerätes an seinem optimalen Arbeitspunkt oft dazu führt, dassein dem Klimatisierungsgerät in dem Klimatisierungskreislauf vorangehendes oder nachfolgendes weiteres Klimatisierungsgerät weit außerhalb seines optimalen Betriebspunktes betrieben wird beziehungsweise werden muss.

EP 1 919 271 A2 offenbart ein Klimatisierungssystem zur Kühlung mehrerer Rechneranlagen (Server, Speichereinheit, etc.). Das Klimatisierungssystem umfasst eine einzelne Klimaanlage und jeweils einen Eingangsventilator und einen Ausgangsventilator für jede Rechneranlage. Laut einer Ausführungsform des bekannten Verfahrens werden die Ventilatoren unmittelbar in Abhängigkeit von der an den Ventilatoren gemessenen Temperaturen gesteuert.

US2006/0168975 A1 betrifft ein Luftstrom-Verteilungssystem mit einer Anzahl an Ventilatoren und Durchflusssensoren. Mittels eines Reglers wird versucht, den Luftstrom in einem Serverraum mit mehreren Servern zu steuern, um eine optimale Kühlung zu erzielen. Es werden alternative Ausführungsformen für eine manuelle und für eine automatische Steuerung der Ventilatoren vorgeschlagen.

In WO 2008/127344 A1 wird ein Klimatisierungsaufbau mit Kaltgangeinhausungen vorgeschlagen. Mittels komplexer Raumteilungsausführungen sollen hierbei Luftströme mit unterschiedlichen Temperaturen voneinander getrennt geführt werden, um eine Durchmischung und somit einen Effizienzverlust zu vermeiden.

JP 2003 116219 A betrifft die Optimierung des Gesamt-Energieverbrauchs mehrerer Lasten, welche an einer Energieversorgung angeschlossen sind.

EP 0741269 A2 betrifft ein Klimatisierungssystem für eine Anordnung elektronischer Baugruppen, in dem mehrere Sensoren verteilt sind. Ferner ist jedem Baugruppenträger ein Ventilator zugeordnet. Ene Steuervorrichtung steuert die Ventilatoren in Abhängigkeit der gemessenen Temperaturwerte.

Es ist Aufgabe der vorliegenden Erfindung, ein Regelungsverfahren und ein Klimatisierungssystem bereitzustellen, mit denen der Energiebedarf für die Klimatisierung mehrerer Verbraucher vermindert werden kann.

Die Aufgabe wird gemäß der Erfindung durch ein Regelungsverfahren mit den Merkmalen des Anspruchs 1 und durch ein Klimatisierungssystem mit den Merkmalen des Anspruchs 14 gelöst. Vorteilhafte Weiterbildungen der Erfindung sind in den Unteransprüchen aufgeführt.

Die Erfindung beruht auf dem Grundgedanken, das Klimatisierungssystem als eine Systemeinheit zu betrachten und seinen Gesamtenergiebedarf mittels eines übergeordneten Regelungsalgorithmus zu minimieren. Die einzelnen Komponenten des Klimatisierungssystems werden also nicht wie sonst üblich einzeln geregelt und jede für sich auf einen optimalen Arbeitspunkt hin gesteuert, an dem sie individuell einen minimalen Energiebedarf aufweisen. Vielmehr wird versucht, mittels des Regelungsalgorithmuseinen optimalen Arbeitspunkt für ein Gesamtsystem aus zumindest dem ersten und dem zweiten Klimatisierungsgerät zu erreichen, wobei in Kauf genommen wird, dassdie einzelnen Komponenten möglicherweise individuell nicht ein einem eigenen energetisch optimalen Arbeitspunkt arbeiten. Der Gesamt energiebedarf wird hierdurch jedoch wesentlich vermindert.

Die thermische Beeinflussung zwischen dem ersten Klimatisierungsgerät und dem zweiten Klimatisierungsgerät mittels des Klimatisierungsmediums im Sinne der Erfindung bedeutet, dass zumindest eines der Klimatisierungsgeräte auf das andere Klimatisierungsgerät thermisch einwirkt. Diese thermische Enwirkung wird durch das Klimatisierungsmedium vermittelt. Hierbei kann es sich beispielsweise um ein Fluid handeln, das von einem aussendenden Klimatisierungsgerät zu einem empfangenden Klimatisierungsgerät strömt. Das aussendende Klimatisierungsgerät sorgt hierbei dafür, dass das Klimatisierungsmedium eine bestimmte Temperatur aufweist. Diese Temperatur wird mittels des Regelungsalgorithmus aufgrund einer Gesamtbetrachtung des Klimatisierungssystems ermittelt und mittels Einstellen von Einstellgrößen des ersten und / oder des zweiten Klimatisierungsgerätes beeinflusst.

Als Einstellgrößen kommen hierbei alle einstellbaren Parameter in Frage, beispielsweise Spannungen, Ströme, Strömungsgeschwindigkeiten, Temperatur, Druck von Fluiden, Schwellwerte, Ventileinstellungen und dergleichen. In der vorliegenden Beschreibung handelt es sich bei Einstellgröße um Mittels einer Steuerung oder eines Regelungssystems unmittelbar einstellbare Parameter. Demgegenüber sind Regelgrößen Parameter, die nur mittelbar mittels Einstellung der Einstellgrößen auf einen gewünschten Wert geregelt werden können. Beispielsweise handelt es sich bei einer gewünschten Temperatur in einem Kaltgang um eine Regelgröße, welche mit Hilfe eines Reglers dadurch erreicht werden kann, dass Einstellgrößen an einem den Kaltgang mit Kaltluft beliefernden Umluftkühlgerät variiert werden, bis die gewünschten Temperatur im Kaltgang erreicht ist.

Mit dem Merkmal der gezielten thermischen Beeinflussung zwischen den ersten und den zweiten Klimatisierungsgeräten ist das erfindungsgemäße Verfahren beispielsweise gegenüber lediglich einer nebeneinander Anordnung von zwei oder mehr Lüftern in einem Rechnergehäuse und ihrer gemeinsamen Ansteuerung abzugrenzen. Es ist jedoch in einer allgemeinen Ausführungsform nicht notwendig, dass ein das Klimatisierungsmedium bildendes Fluid vollständig von einem Klimatisierungsgerät zum anderen Klimatisierungsgerät strömt.

Als Energiebedarf eines Klimatisierungsgerätes wird jene Energie angesehen, die zum Betrieb des Klimatisierungsgerätes notwendig ist. Dieser Energiebedarf kann hierbei durch ein Regelungssystem, durch ein für mehrere oder für alle Klimatisierungsgeräte gemeinsames und / oder durch eine individuelle Energieversorgung gedeckt werden. Der mittels des Regelungsalgorithmus zu minimierende Gesamtenergiebedarf stellt sich als Summe zusammen aus dem Energiebedarf eines oder mehrerer ersten Klimatisierungsgeräte und dem Energiebedarf eines oder mehrerer zweiter Klimatisierungsgeräte. Hierbei schließt der Begriff Energiebedarf die von den einzelnen Komponenten verbrauchte Energie in Joule, in einer bestimmten Zeiteinheit mit ein, zum Beispiel in einer Stunde, in einem Tag oder in einer Woche etc. Alternativ kann der Regelungsalgorithmus mit einem Leistungsbedarf in Joule pro Sekunde rechnen. Die Energiebedarfsminimierung im Sinne der vorliegenden Beschreibung bei allen Ausführungsformen bezieht sich also vorzugsweise auf eine Leistungsbedarfsminimierung. Es ist nicht zwingend notwendig, dass zur Ermittlung des Gesamtenergiebedarfs eine Summenbildung im Sinne einer mathematischen Summierung von Energieverbrauchswerten im Regelungssystem erfolgt. Beispielsweise kann der Gesamtenergiebedarf auch als Energieverbrauch an der Energieversorgung des Klimatisierungssystems direkt gemessen werden.

Bei einer bevorzugten Ausführungsform ist vorgesehen, dass die thermische Beeinflussung einen Austausch des Klimatisierungsmediums zwischen dem ersten Klimatisierungsgerät und dem zweiten Klimatisierungsgerät umfasst. Bei einem durch ein Fluid gebildetes Klimatisierungsmedium bedeutet dies, dass das Klimatisierungsmedium in beiden Richtungen strömt, also sowohl von dem ersten Klimatisierungsgerät zum zweiten Klimatisierungsgerät als auch anschließend vom zweiten Klimatisierungsgerät zum ersten Klimatisierungsgerät. In einer speziellen Ausbildung dieser Ausführungsform strömt das Klimatisierungsmedium vollständig in einem Kreislauf von einem zum anderen Klimatisierungsgerät und wieder zurück, ohne dass ein wesentlicher Anteil das Klimatisierungsmedium aus dem Kreislauf tritt.

In einer vorteilhaften Weiterbildung ist vorgesehen, dass das erste Klimatisierungsgerät in einem Satz erster Klimatisierungsgeräte funktional zu einer ersten Geräteebene zusammengefasst ist und dass das zweite Klimatisierungsgerät in einem Satz zweiter Klimatisierungsgeräte funktional zu einer zweiten Geräteebene zusammengefasst ist, wobei zwischen den ersten Klimatisierungsgeräten der ersten Geräteebene und den zweiten Klimatisierungsgeräten der zweiten Geräteebene die thermische Beeinflussung mittels des Klimatisierungsmediums erfolgt und mittels des Regelungsalgorithmus ein Gesamtenergiebedarf minimiert wird, welcher als Summe eines Energiebedarfs eines der oder aller ersten Klimatisierungsgeräte und eines Energiebedarfs eines der oder aller zweiten Klimatisierungsgeräte gebildet wird, indem erste Einstellgrößen des einen, mehrerer der oder aller ersten Klimatisierungsgeräte und zweite Einstellgrößen des einen, mehrerer der oder aller zweiten Klimatisierungsgeräte gesteuert werden.

Die funktionale Zusammenfassung bedeutet, dass die Klimatisierungsgeräte einer Geräteebene in dem Klimatisierungssystem ähnliche oder gleiche Funktionen erfüllen. Zudem haben vorzugsweise die ersten Klimatisierungsgeräte, die zweiten Klimatisierungsgeräte und / oder gegebenenfalls weitere Klimatisierungsgeräte einer Geräteebene jeweils untereinander einen ähnlichen oder im Wesentlichen identischen Aufbau.

Gemäß einer zweckmäßigen Ausgestaltung ist vorgesehen, dass der Gesamtenergiebedarf, welcher mittels des Regelungsalgorithmus minimiert wird, als Summe einen Gesamtenergiebedarf aller ersten Klimatisierungsgeräte der ersten Geräteebene und / oder einen Gesamtenergiebedarf aller zweiten Klimatisierungsgeräte der zweiten Geräteebene umfasst. Der Regelungsalgorithmus kann bei der Minimierung des Gesamtenergiebedarfs in einer vereinfachten Ausführungsform nur lediglich jeweils einen oder mehrere Klimatisierungsgeräte pro Geräteebene in die Regelung einbeziehen. Auch diese einfachere Form der übergreifenden Regelung kann zu einer erheblichen Reduktion des Energiebedarfs führen. Beispielsweise können mehrere Regelungssysteme vorgesehen sein, die jeweils einen eigenen Klimatisierungskreislauf aus einem oder mehreren ersten und einem oder mehreren zweiten Klimatisierungsgeräten regeln. Vorzugsweise wird jedoch der Energiebedarf des gesamten Klimatisierungssystems der Minimierung mittels eines einzelnen Regelungssystems unterzogen.

Bevorzugterweise ist vorgesehen, dass einem oder mehreren der zweiten Klimatisierungsgeräten der zweiten Geräteebene eines oder mehrere der ersten Klimatisierungsgeräte der ersten Geräteebene derart zugeordnet werden, dass die thermische Beeinflussung mittels des Klimatisierungsmediums im Wesentlichen ausschließlich zwischen dem einen oder den mehreren der zweiten Klimatisierungsgeräte und dem einen oder den mehreren der ersten Klimatisierungsgeräte erfolgt. Hierbei können zwei oder mehr der ersten Klimatisierungsgeräte gemeinsam einen einzelnen der zweiten Klimatisierungsgeräte thermisch beeinflussen. Die Zuordnung kann beispielweise geschehen, indem Verbindungen zwischen den jeweiligen Klimatisierungsgeräten getrennt und / oder neu geknüpft werden.

Bei einer zweckmäßigen Ausführungsform ist vorgesehen, dass die Zuordnung der ersten Klimatisierungsgeräte zu den zweiten Klimatisierungsgeräten über mehrere Vermittlungsvorrichtungen erfolgt, welche das Klimatisierungsmedium zwischen den ersten Klimatisierungsgeräten und den zweiten Klimatisierungsgeräten vermitteln, indem einer der Vermittlungsvorrichtungen einem oder mehreren der ersten Klimatisierungsgeräte derart zugeordnet werden, dass die thermische Beeinflussung zwischen dem einen oder den mehreren der ersten Klimatisierungsgeräte und dem einen oder den mehreren der zweiten Klimatisierungsgeräte mittels des Klimatisierungsmediums im Wesentlichen ausschließlich über die eine der Vermittlungsvorrichtungen erfolgt. Zuordnung über eine Vermittlungsvorrichtung bedeutet somit, dass zuerst eine Zuordnung zwischen ersten Klimatisierungsgeräten und der Vermittlungsvorrichtung erfolgt, wobei im Anschluss hieran oder auch zuvor eine Zuordnung zwischen Vermittlungsvorrichtung und zweiten Klimatisierungsgeräten erfolgt. Eine derartige Vermittlungsvorrichtung kann einen Kaltgang umfassen, welcher das Klimatisierungsmedium, in diesem Fall Kaltluft, von einem oder mehreren ersten Klimatisierungsgeräten zu mehreren zweiten Klimatisierungsgeräten leitet.

In einer vorteilhaften Ausgestaltung ist vorgesehen, dass die Zuordnung der ersten Klimatisierungsgeräte zu den zweiten Klimatisierungsgeräten automatisch erfolgt. Beispielweise kann hierzu eine Zuordnungsmatrix geführt werden, in der eine aktuelle Zuordnung hinterlegt wird. Physikalisch kann die Zuordnung zum Beispiel über Ventilsysteme erfolgen. Insbesondere ist bei einer bevorzugten Weiterbildung vorgesehen, dass der Regelungsalgorithmus die Zuordnung der ersten Klimatisierungsgeräte zu den zweiten Klimatisierungsgeräten derart durchführt, dass der Gesamtenergiebedarf minimiert wird. Mit anderen Worten, die Zuordnung zwischen den Klimatisierungsgeräten der unterschiedlichen Geräteebenen dient selbst als Einstellgröße, die durch das Regelungssystem gesteuert wird, um den Gesamtenergiebedarf zu minimieren.

Vorteilhafterweise ist vorgesehen, dass das Klimatisierungssystem zumindest ein oder mehrere weitere Klimatisierungsgeräte umfasst, welche funktional zu einer oder mehreren weiteren Geräteebenen zusammengefasst sind, wobei zwischen den ersten Klimatisierungsgeräten der ersten Geräteebene oder den zweiten Klimatisierungsgeräten der zweiten Geräteebene und den weiteren Klimatisierungsgeräten der weiteren Geräteebene eine thermische Beeinflussung mittels eines oder mehrerer weiterer Klimatisierungsmedien erfolgt und der Gesamtenergiebedarf, welcher mittels des Regelungsalgorithmus minimiert wird, als Summe einen Gesamtenergiebedarf eines oder aller weiterer Klimatisierungsgeräte der einen oder mehreren weiteren Geräteebenen umfasst. Die weiteren Klimatisierungsgeräte können den ersten Klimatisierungsgeräten vorgeschaltet und / oder den zweiten Klimatisierungsgeräten nachgeschaltet sein. Die weiteren Klimatisierungsmedien können sich von den zwischen den ersten und den zweiten Klimatisierungsgeräten verwendeten Klimatisierungsmedien in ihren physikalischen Eigenschaften unterscheiden. Beispielsweise können sie in unterschiedlichen Aggregatzuständen vorliegen.

Gemäß einer bevorzugten Ausgestaltung ist vorgesehen, dass mehrere oder alle Klimatisierungsgeräte einer Geräteebene räumlich zusammengefasst in einem oder mehreren Baugruppen untergebracht sind. Dies kann darüber hinaus auch für mehrere Klimatisierungsgeräte aus unterschiedlichen Geräteebenen gelten. Die Baugruppen können mobil gestaltet sein.

Bevorzugterweise ist vorgesehen, dass mehrere oder alle Klimatisierungsgeräte einer Geräteebene räumlich getrennt angeordnet sind. Die räumlich getrennten Klimatisierungsgeräte können in einem Raum, in dem sich das Klimatisierungssystem befindet, verteilt aufgestellt sein. Sie können aber auch zum Teil in unterschiedlichen Räumen, Etagen und / oder Gebäuden angeordnet sein.

In einer zweckmäßigen Weiterbildung ist vorgesehen, dass als Klimatisierungsmedium und / oder als weiteres Klimatisierungsmedium ein flüssiges und / oder ein gasförmiges Medium verwendet wird. Derartige Fluide können beispielsweise Wasser oder Luftgemische umfassen, in denen gegebenenfalls Zusatzstoffe beigemischt sind, um ihre chemischen und / oder physikalischen Eigenschaften zu beeinflussen, beispielsweise ihre Wärmeleitfähigkeit zu optimieren. Insbesondere können sich inerte Gase als Klimatisierungsmedium und / oder als weiteres Klimatisierungsmedium eignen.

Zweckmäßigerweise ist vorgesehen, dass die erste, die zweite und / oder die weitere Geräteebene eine Kälteerzeugerebene, eine Umluftkühlgerätebene und / oder eine Verbraucherkühlgerätebene umfassen. Die Kälteerzeugerebene umfasst Kälte erzeugende Anlagen wie sogenannte Free Cooling Systeme (auch häufig als Kältemaschinen oder Chiller bezeichnet), Kaltwassersätze und dergleichen. Bei den Verbraucherkühlgeräten handelt es sich beispielsweise um On-Board-Lüfter von Rechnersystemen und dergleichen. Wie teilweise vorangehend erläutert, können zwischen den Umluftkühlgeräten und den Verbraucherkühlgeräten Vermittlungsvorrichtungen vermitteln, die sowohl Kaltgang- als auch Warmgangeinhausungen umfassen können.

Die Erfindung wird im Folgenden anhand von Ausführungsbeispielen unter Bezugnahme auf die Figuren erläutert. Hierbei zeigen:

Fig. 1 ein Aufbaudiagramm ein Klimatisierungssystem mit drei hintereinandergeschalteten Klimatisierungsgeräten;

Fig. 2 ein Aufbaudiagramm eines weiteren Klimatisierungssystems mit drei aufeinanderfolgenden Geräteebenen;

Fig. 3 ein Aufbaudiagramm eines Klimatisierungssystems mit drei Geräteebenen und zwischen zwei Geräteebenen vermittelnden Vermittlungsvorrichtungen;

Fig. 4 eine Zuordnung von Vermittlungsvorrichtungen zu ersten Klimatisierungsgeräten in einer schematische Ansicht;

Fig. 5 einen Flussdiagramm eines als geschlossener Kreis ausgelegten Regelungsalgorithmus für ein Klimatisierungssystem; und

Fig. 6 ein Diagramm zur Beschreibung eines Schutzebenen-Modells.

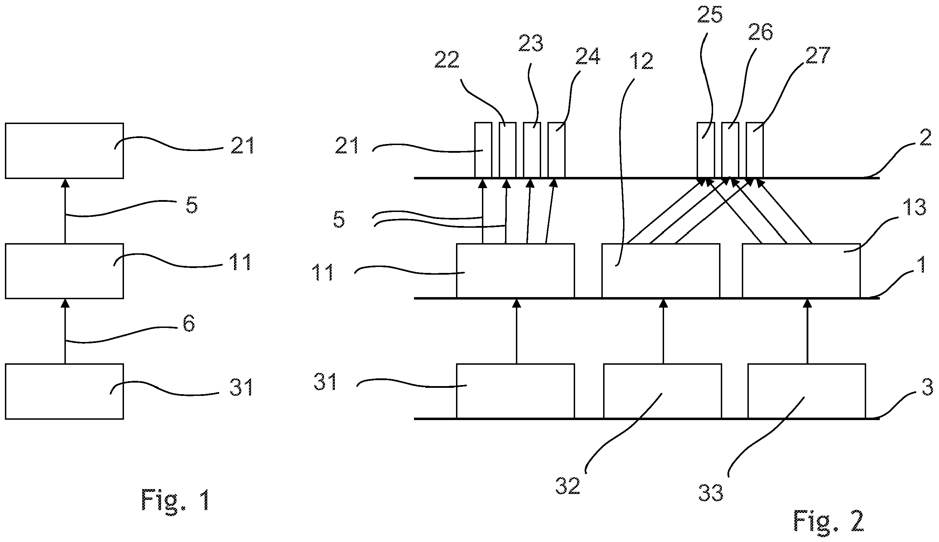

Die Fig. 1 zeigt schematisch den Aufbau eines Klimatisierungssystems mit einem Kälteerzeuger 31, beispielsweise einem Chiller, einem Umluftkühlgerät 11 und einem Verbraucherkühlgerät 21. Bei dem Verbraucherkühlgerät 21 handelt es sich um einen im Gehäuse eines Verbrauchers, beispielsweise einer Elektronikbaugruppe oder eines Rechnersystems, eingebauten Lüfter. Er wird durch das Umluftkühlgerät 11 mit einem Klimatisierungsmedium 5 versorgt, welches das Verbraucherkühlgerät 21 verwendet, um den ihm zugeordneten Verbraucher (in den Figuren nicht dargestellt) auf eine geeignete Temperatur zu kühlen. Das Umluftkühlgerät 11 ist vorzugsweise mit einem regelbaren elektrisch kommutierten Motor ausgestattet.

Um das Klimatisierungsmedium 5 auf eine für diese Zwecke geeignete Temperatur halten zu können, bezieht das Umluftkühlgerät 11 selbst ein weiteres Klimatisierungsmedium 6 von den Kälteerzeuger 31. Im vorliegenden Fall handelt es sich bei dem weiteren Klimatisierungsmedien 6 um Kühlwasser, welches in einem Kreislauf zwischen dem Kälteerzeuger 31 und dem Umluftkühlgerät 11 strömt. In dem Kälteerzeuger 31 wird das Kühlwasser heruntergekühlt und dem Umluftkühlgerät 11 zugeleitet. Das Umluftkühlgerät 11 verwendet das Kühlwasser, um das Klimatisierungsmedium 5 zu kühlen. Hierbei wird das Kühlwasser aufgewärmt und anschließend zurück zum Kälteerzeuger 31 geleitet. Bei dem Klimatisierungsmedium 5 handelt es sich um Luft, welches das Umluftkühlgerät 11 durchströmt und hierbei abgekühlt wird. Anschließend wird die abgekühlte Luft zum Verbraucherkühlgerät 21 geleitet, wo es zum Kühlen des Verbrauchers verwendet wird. Bei der thermischen Beeinflussung des Umluftkühlgerätes 11 durch den Kälteerzeuger 31 handelt es sich somit um einen Austausch des weiteren Klimatisierungsmediums 6, bei dem das weitere Klimatisierungsmedien 6 in beiden Richtungen zwischen dem Umluftkühlgerät 11 und dem Kälteerzeuger 31 strömt.

In einem herkömmlichen Klimatisierungssystem werden die einzelnen Komponenten, nämlich Kälteerzeuger, Umluftkühlgerät und Verbraucherkühlgerät, derart geregelt, dass jede Komponente für sich genommen in einem optimierten Arbeitspunkt gehalten wird, der einem minimalen Energieverbrauch entspricht. Demgegenüber wird im vorliegenden Klimatisierungssystem der Gesamtenergieverbrauch minimiert, indem mehrere oder vorzugsweise alle zur Verfügung stehenden Einstellgrößen anhand eines Regelungsalgorithmus gesteuert werden, so dass bestimmte Regelgrößen in akzeptablen Wertebereichen liegen.

Ein Beispiel einer derartigen Regelgröße ist die Temperatur des durch den Kälteerzeuger 31 bereitgestellten weiteren Klimatisierungsmediums 6, bei dem es sich um Kühlwasser handelt. Anhand eines Temperatursensors kann diese Regelgröße beobachtet werden. Beeinflusst wird sie durch das Steuern von Einstellgrößen an dem Kälteerzeuger 31, beispielsweise eines Kompressionsverhältnisses bei Kompressionskältemaschinen. In einem ersten Schritt des Regelungsverfahrens kann der Kälteerzeuger 31 das weitere Klimatisierungsmedium 6 auf eine bestimmte Temperatur regeln, beispielsweise auf etwa 16 °C. Das Umluftkühlgerät 11 verwendet das so abgekühlte weitere Klimatisierungsmedium 6, um das Klimatisierungsmedium 5 herunter zu kühlen, beispielsweise auf ebenfalls etwa 16 °C, und an das Verbraucherkühlgerät 21 zu leiten. Wenn sich im Laufe des Regelungsverfahren herausstellt, dass der Verbraucher auch mit einer höheren Betriebstemperatur effizient arbeiten kann, und dass somit das Klimatisierungsmedium 5 und / oder das weitere Klimatisierungsmedium 6 eine höhere Temperatur aufweisen dürfen, beispielsweise etwa 21 °C, so wird dies von dem Verbraucherkühlgerät 21 über eine Schnittstelle dem Regelungssystem mitgeteilt, welches dafür sorgt, dass der Kälteerzeuger 31 und / oder das Umluftkühlgerät 11 entsprechend geregelt werden. Auf diese Weise wird die Energie eingespart, welche dazu notwendig wäre, die jeweiligen Temperaturen auf den niedrigeren Werten zu halten.

Die Fig. 2 zeigt den schematischen Aufbau des Klimatisierungssystems in einer weiteren Ausführungsform. Das Klimatisierungssystem umfasst eine Umluftkühlgerät-Ebene 1, eine Verbraucherkühlgerät-Ebene 2 und eine Kälteerzeuger-Ebene 3. Auf der Kälteerzeuger-Ebene 3 sind drei Kälteerzeuger 31, 32, 33 dargestellt, welche jeweils ein Umluftkühlgerät 11, 12, 13 aus der Umluftkühlgerät-Ebene 1 mit dem weiteren Klimatisierungsmedium 6, beispielsweise Kühlwasser, versorgen. Die Umluftkühlgeräte 11, 12, 13 der Umluftkühlgerät-Ebene 1 wiederum beeinflussen thermisch im Klimatisierungssystem nachgelagerte Verbraucherkühlgeräte 21, 22, ..., welche in der Verbraucherkühlgerät-Ebene 2 funktional zusammengefasst sind.

EP 2 483 605 B1

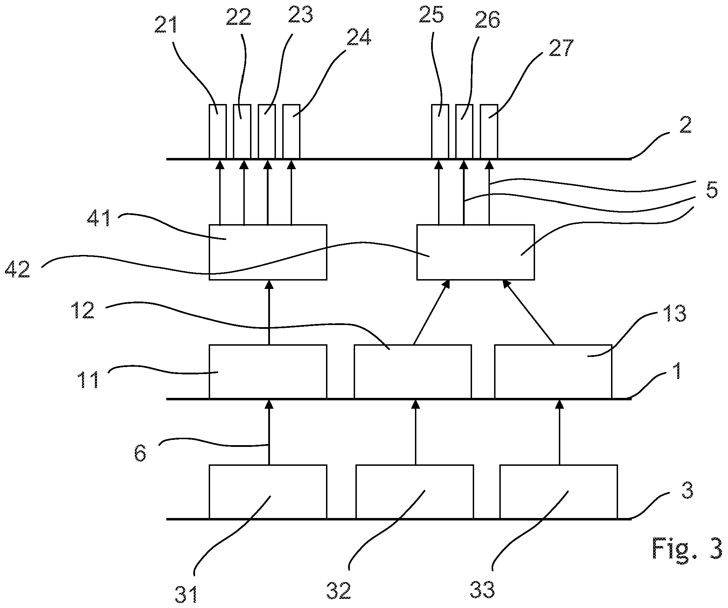

Wie in der Fig. 2 ersichtlich ist, versorgt eines der Umluftkühlgeräte 11 alleine mehrere Verbraucherkühlgeräte 21, 22, 23, 24, während weitere Verbraucherkühlgeräte 25, 26, 27 durch zwei weitere Umluftkühlgeräte 12, 13 gemeinsam versorgt werden. Dies geschieht in der in Fig. 3 dargestellten Ausführungsform über Vermittlungsvorrichtungen 41, 42, bei denen es sich insbesondere um Kaltgänge 41, 42 handeln kann. Indem die Umluftkühlgeräte 11, 12, 13 den Kaltgängen 41, 42, zugeordnet sind, findet gleichzeitig eine Zuordnung zwischen den Umluftkühlgeräten 11, 12, 13 und den Verbraucherkühlgeräten 21, 22, ... der die Kaltgänge 41, 42 umsäumenden Verbraucher statt. In der in Fig. 3 dargestellten Ausführungsform sind vier der Verbraucherkühlgeräte 21, 22, 23, 24 gezeichnet, welche an dem einen Kaltgang 41 angrenzen, während drei der an dem anderen Kaltgang 42 angrenzenden Verbraucherkühlgeräte 25, 26, 27 dargestellt sind.

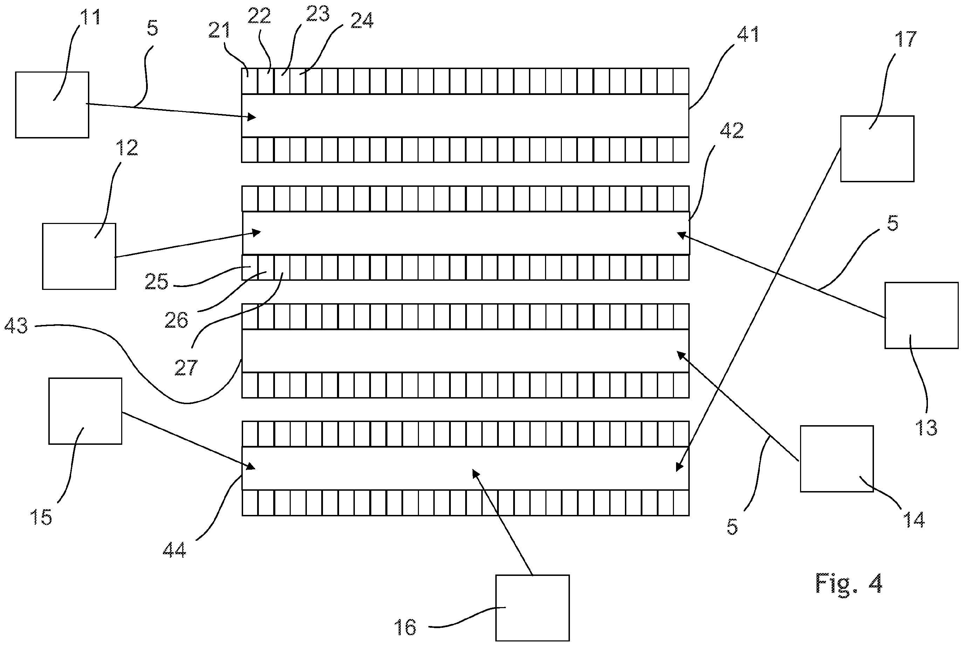

Die Zuordnung der Umluftkühlgeräte 11, 12, ... zu den Kaltgängen 41, 42, ... wird in der Fig. 4 veranschaulicht, wobei hier die räumliche Verteilung der Umluftkühlgeräte 11, 12, ... und der Kaltgänge 41, 42, ... schematisch angedeutet ist. Die Zuleitung des Klimatisierungsmediums 5 von den Umluftkühlgeräten 11, 12, ... zu den Kaltgängen 41, 42, ... erfolgt vorzugsweise über Leitungen, welche unterhalb einer Fußbodenbedeckung verlaufen und das Klimatisierungsmedium 5 durch Bodenklappen beziehungsweise Gitterroste in die Kaltgänge 41, 42, ... führen. Wie in der Fig. 4 dargestellt, wird eines der Kaltgänge 41 von zwei parallel angeordneten Reihen von Verbrauchern umsäumt, welche die Verbraucher umfassen, die den in Fig. 3 dargestellten vier Verbraucherkühlgeräten 21, 22, 23, 24 zugeordnet sind. Über den angrenzenden Kaltgang 41 werden diese Verbraucherkühlgeräte 21, 22, 23, 24 mit dem Klimatisierungsmedium 5 vom zugeordneten Umluftkühlgerät 11 versorgt.

Während zwei der Kaltgänge 41, 43 aus der Fig. 4 jeweils durch ein Umluftkühlgerät 11, 14 versorgt werden, sind anderen Kaltgängen 42, 44 zwei oder sogar drei Umluftkühlgeräte 12 und 13 beziehungsweise 14, 15 und 16 zugeordnet. Die Zuordnung kann entweder manuell oder automatisch erfolgen, um eine für die Minimierung des Gesamtenergieverbrauchs des Klimatisierungssystems optimale Zuordnung zwischen Umluftkühlgeräten 11, 12, ... und Verbraucherkühlgeräten 21, 22, ... zu erreichen.

Im Folgenden wird ein auf einem Regelungssystem ablaufender Regelungsalgorithmus in einer bevorzugten Ausführungsform im Detail erläutert. Das hierbei verwendete Klimatisierungssystem ähnelt im Wesentlichen der anhand der Fig. 3 und 4 dargestellten Ausführungsform, bei dem eine Reihe von Kälteerzeuger 31, 32, 33 jeweils ein Umluftkühlgerät 11, 12, ... mit Kühlwasser versorgen und die Umluftkühlgeräte 11, 12, ... ihrerseits eingesaugte Luft herunterkühlen und in eine Reihe von Kaltgängen 41, 42, ... einspeisen, von wo die Luft durch die, die Kaltgänge umsäumende, Verbraucher beziehungsweise durch ihre Verbraucherkühlgeräte 21, 22, ... geleitet wird.

In dieser Ausführungsform werden zur Ermittlung des Gesamtenergieverbrauchs des gesamten Klimatisierungssystems standardmäßige Messgeräte für die Ermittlung eingesetzt, und mit ihnen der momentane Leistungsbedarf beziehungsweise der momentane Energieverbrauch gemessen. Dabei messen diese Messgeräte den Verbrauch der Verbraucherkühlgeräte, wobei die Messung gegebenenfalls an Ausgängen von Stromversorgungen wie beispielsweise unterbrechungsfreien Stromversorgungsanlagen (USV-Anlagen), an Abgängen zu den Umluftkühlgeräten 11, 12, ... und / oder an Abgängen zu den Kälteerzeugern 31, 32, ... einschließlich der zu ihrem Betrieb notwendigen Pumpen vorgenommen werden.

Die Messgeräte verfügen über geeignete Schnittstellen zur Kommunikation mit dem Regelungssystem. Mit diesen Messgeräten werden die Verbrauchswerte ermittelt. Jedes Klimatisierungsgerät, also alle Umluftkühlgeräte 11, 12, ..., Kältemaschinen (oft als Chiller bezeichnet) inklusive ihrer Pumpen etc., ist mit entsprechenden Messgeräten und Sensoren ausgestattet, beispielsweise zur Temperatur-, Leistungs- bzw. Energiewert-, Druck- und Feuchtigkeitserfassung. Die einzelnen Klimatisierungsgeräte haben digitale protokollbasierte oder analoge Schnittstellen, so dass ihre Einstellparameter durch das Regelungssystem verändert werden können.

Das Regelungssystem ermittelt nun den Gesamtenergieverbrauch aller Komponenten des Klimatisierungssystems und minimiert durch den subsystemübergreifende Regelungsalgorithmus den Energieverbrauch des Gesamtsystems, indem Einstellgrößen der einzelnen Klimatisierungsgeräte geändert werden. Mit in dem Regelungsalgorithmus werden auch die als Wärmeerzeuger wirkenden Verbraucher mit ihren Verbraucherkühlgeräten 21, 22, ... berücksichtigt, beispielsweise in Rechnergehäusen installierte Lüfter. Die Verbraucherkühlgeräte 21, 22, ... sind gekennzeichnet durch ihren Stromverbrauch, der wiederum von der in den zugehörigen Kaltgängen 41, 42, ... angebotenen Luft-Temperatur abhängig ist. Moderne Rechnersysteme haben On-Board ein eigenes Lüfter-Regelungssystem, das den Kühlbedarf des zugehörigen Rechners regelt. Der Kühlbedarf kann als Datensatz durch entsprechende Verbrauchsmesstechnik oder direkt über eine On-Board-Schnittstelle des Verbraucherkühlgerätes 21, 22, ... ermittelt werden. Das Regelungssystem hat Zugriff auf diese Daten und verwendet sie zur Gesamtenergieminimierung des Klimatisierungssystems.

Warm- und / oder Kaltgänge 41, 42, ... für die Verbraucher werden ebenfalls in den Regelungsalgorithmus integriert beziehungsweise mit berücksichtigt. Hierbei ist darauf zu achten, dass Warmgänge und / oder Kaltgänge 41, 42, ... mittels geeigneter Warmgang- beziehungsweise Kaltgangeinhausungen mit Hilfe von Abdichtungen voneinander thermisch stringent getrennt werden, um ein Maximum an Energieverbrauchsminimierung zu erreichen.

Die Temperatur in den Kaltgängen 41, 42, ... wird durch das Regelungssystem derart geregelt, dass ein minimaler Gesamtenergiebrauch der Verbraucherkühlgeräte 21, 22, ... an den Kaltgängen 41, 42, ... angrenzender Verbraucher erreicht wird. Es gilt für die Wirkleistung und für den Energieverbrauch folgende Beziehung:

$$P_{gesamt} = Minimum[P_{Kälteerzeuger}+P_{ULK}+P_{Verbraucher}]$$

$$E_{gesamt} = Minimum[E_{Kälteerzeuger}+E_{ULK}+ E_{Verbraucher}]$$

Wobei $E_{gesamt}$ die Gesamtenergie, $E_{Kälteerzeuger}$ die durch die Kälteerzeuger verbrauchte Energie, $E_{ULK}$ die durch die Umluftkühlgeräte verbrauchte Energie $E_{Verbraucher}$ die durch die Verbraucherkühlgeräte verbrauchte Energie kennzeichnen. Entsprechende Begriffszuordnungen gelten für die Leistungswerte $P_{gesamt}$, $P_{Kälteerzeuger}$, $P_{ULK}$ und $P_{Verbraucher}$.

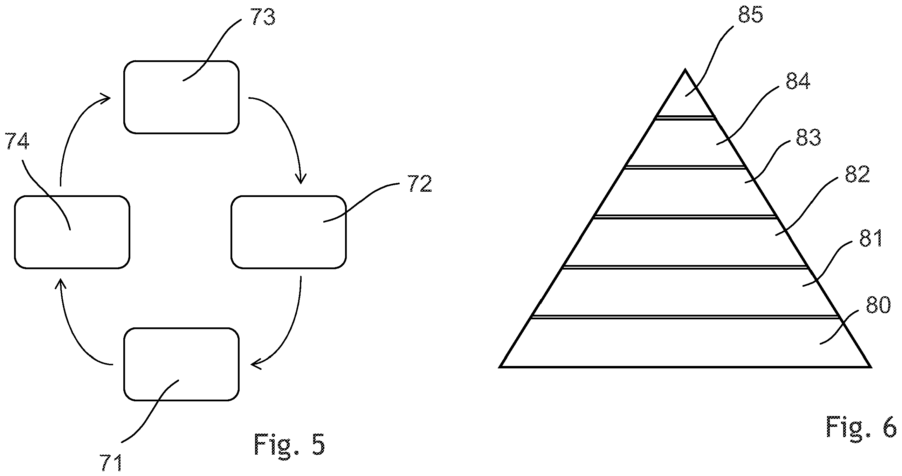

Der Regelungsalgorithmus wird in einer Art geschlossenen Kreislauf durchgeführt, was anhand eines Einflussdiagramms in der Fig. 5 veranschaulicht wird. Die Rechecke 71 bis 74 stellen hierbei die Regelungsvorgänge dar, während die Pfeile jeweils den Einfluss eines derartigen Regelungsvorgangs auf den nachfolgenden Regelungsvorgang verdeutlichen. Zur Durchführung des Regelungsalgorithmus kann das Regelungssystem herkömmliche Regler wie PID-Regler, PI-Regler und dergleichen oder auch neuere Reglertypen wie beispielsweise Fuzzy-Regler beziehungsweise adaptive Regelalgorithmen einsetzen. Dies gilt sowohl für die Regelung einzelner Komponenten des Klimatisierungssystems als auch für eine systemüberspannende Regelung.

Beginnend mit einer Kaltgangregelung 71 wird in einem der Kaltgänge 41, 42, ... mit Hilfe von Temperatursensoren der minimal erzielbare Energieverbrauch für eine gewünschte Temperaturverteilung ermittelt. Hierzu wird eine Umluftkühlregelung 72 durchgeführt, bei dem das Regelungssystem auf die Umluftkühlgeräte 11, 12, ... zugreift und selbstständig gemäß dem Regelungsalgorithmus Einstellgrößen wie Lüfterdrehzahl, Ventilstellung, Vorlauf-/Rücklauftemperatur und dergleichen verändert.

Die Regelung der Umluftkühlgeräte 11, 12, ... ist hierbei vorzugsweise wie folgt aufgebaut: Es werden zunächst Umluftkühlgeräte in Umluftkühlgeräte-Gruppen aufgeteilt, welchen jeweils eine, mehrere oder im Extremfall alle Umluftkühlgeräte 11, 12, ... zugeordnet werden. Jeder Umluftkühlgeräte-Gruppe werden ferner Einstellgrößen der zugehörigen Umluftkühlgeräte 11, 12, ... zugeordnet. Diese Einstellgrößen umfassen beispielsweise eine Drehzahl, eine Ventilstellung für das Kaltwasser, Wassertemperaturen und dergleichen. Eine sinnvolle Aufteilung in Umluftkühlgeräte-Gruppen ergibt sich bei Berücksichtigung des ermittelten minimalen Gesamtenergieverbrauchs des Klimatisierungssystems.

Anschließend werden Kaltgang/Warmgang-Gruppen definiert, denen jeweils eine, mehrere oder alle zur Verfügung stehenden Kaltgänge 41, 42, ... zugeordnet werden. In jedem Kaltgang 41, 42, ... wird an den Ecken oder Enden und in der Kaltgangmitte jeweils ein Temperatursensor installiert, der den dort vorherrschenden Ist-Temperaturwert ermittelt. In einem nächsten Schritt erfolgt eine Zuordnung der Umluftkühlgeräte-Gruppen zu den Kaltgang/Warmgang-Gruppen in der Weise, dass der Energieverbrauch der Umluftkühlgeräte 11, 12, ... in Abhängigkeit von der jeweils anliegenden Verbraucher-Last minimiert wird. Diese Zuordnung entspricht der Zuordnung der Umluftkühlgeräte 11, 12, ... zu den einzelnen Vermittlungsvorrichtungen 31, 32, ..., wie sie vorangehend anhand der Fig. 4 erläutert wurde.

Zur weiteren Gesamtenergieminimierung des Klimatisierungssystems wird während einer Kälteerzeugerregelung 73 die Temperatur des weiteren Klimatisierungsmediums 6 für die Zufuhr an ein jeweiliges Umluftkühlgerät 11, 12, ... dahingehend verändert, dass sich auch hier ein minimaler Energieverbrauch für die Umluftkühlgeräte 11, 12, ... bei vorgegebener Solltemperatur im Kaltgang und vorgegebener Verbraucherlast einstellt. Hierbei wird für die Kälteerzeuger 31, 32, ... eine konstante Temperaturänderung für Vorlauftemperatur und / oder Rücklauftemperatur durch das Regelungssystem eingestellt und der sich hierbei ergebende Energieverbrauch ausgewertet. Die Einstellung der Temperaturänderung wird beispielsweise dadurch erreicht, dass Pumpen für Kaltwassersätze in den Kälteerzeugern 31, 32, ... entsprechend gesteuert werden.

Schließlich findet beim Durchlauf des Regelkreislaufs aus der Fig. 5 auch eine Verbraucherregelung 74 statt, bei der Regelgrößen wie Temperatur und Verbrauchsleistung an den Verbraucherkühlgeräten 21, 22, ... mittels geeigneter Sensoren beobachtet werden, während die Temperaturen in den Kaltgängen 41, 42, ... geregelt werden. Die in der Fig. 5 dargestellten Regelungsschritte 71, 72, 73, 74 sind lediglich schematisch zu betrachten. Es soll hierdurch veranschaulicht werden, dass das Regelungsverfahren in der hier erläuterten Ausführungsform die unterschiedlichen Geräteebenen 1, 2, 3 nacheinander und wiederholt ansteuern kann, um in einem iterativen Prozess den Gesamtenergieverbrauch des Klimatisierungssystems zu minimieren. Außerdem verdeutlicht die Fig. 5, dass die Regelung jeder Geräteebene 1, 2, 3 die Regelgrößen der jeweils benachbarten Geräteebene 1, 2, 3 beeinflusst.

Damit das hier beschriebene Klimatisierungssystem ausfallsicher und robust arbeiten kann, wird sein Regelungssystem vorzugsweise als verteiltes System beziehungsweise als sogenanntes Cloud- oder Distributed-Processing-System mit eigenständigen vernetzten Signalverarbeitungs- oder Rechnersystemen aufgebaut, welche eine Reihe von Verarbeitungsebenen (sogenannte Layers) umfasst. Bei der Vernetzung dieser Ebenen finden auch Sicherheitsprotokolle ihren Einsatz. Das Regelungssystem ist also so aufgebaut, dass es durch einen Ausfall einzelner Komponenten des Regelungssystems oder des Klimatisierungssystems nicht zu einer Gefährdung der Verbraucher kommen kann, die durch das Klimatisierungssystem klimatisiert werden. Die hierbei verwendete Struktur der Schutzebenen ist in der Fig. 6 schematisch dargestellt.

Die unterste Ebene 80 umfasst On-Board-Steuerungssysteme, die an einzelnen Klimatisierungskomponenten wie Kälteerzeuger 31, 32, ..., Umluftkühlgeräte 11, 12, ..., Pumpensteuerungen und dergleichen angebaut sind. Gegebenenfalls herstellerseitig bereitgestellte Sicherheitsfunktionen für diese Komponenten können ebenfalls in dieser untersten Ebene 80 zusammengefasst sein.

Die erste Ebene 81 umfasst Subsysteme des Regelungssystems. In der zweiten Ebene 82 sind an einzelnen Verbrauchern angeordnete Messgeräte untergebracht, während die dritte Ebene 83 die Alarmebene bildet. Schließlich wird in der vierten Ebene 84 das Monitoring des Energieverbrauchs zusammengefasst, während ein sogenanntes Reporting, inklusive einer automatischen Energieverbrauchszusammenstellung und Rechnungsstellung in der fünften Ebene 85 durchgeführt werden kann.

In der ersten bis dritten Schutzebene 81, 82, 83 können auch Funktionalitäten des sogenannten Sicherheits-Integritätslevels (SIL) für den Fall des Ausfalls des Regelungssystems zusätzlich implementiert werden. Dies bedeutet, dass sich einzelne Komponenten des Klimatisierungssystems wie Umluftkühlgeräte 11, 12, ..., Kälteerzeuger 31, 32, ... und dergleichen bei Ausfall von Komponenten des Regelungssystems selbständig in Ihren jeweiligen ungeregelten Zustand mit maximaler Kühlleistung begeben.

Die Schutzebenen 80, 81, ... des Regelungssystems sind in Ihrer Funktion voneinander unabhängig und können durch geeignete gesicherte Protokolle miteinander verbunden sein. Diese unterschiedlichen Schutzebenen 80, 81, ... sind hierarchisch aufgebaut und jeweils unabhängig voneinander zu betrachten. Versagt eine Schutzebene 80; 81; ..., dann greift automatisch die nächsthöhere Schutzebene 81; 82; ... zur Schadensbegrenzung oder - vermeidung ein. Dies gilt zumindest bis einschließlich der dritten Ebene 83. Weiterhin sind in einer Ebene untergebrachte Komponenten nicht gleichzeitig Teil einer anderen Ebene.

Bezugszeichenliste:

| | |
|---|---|
| 1 | Umluftkühlgerät-Ebene (erste Geräteebene) |
| 11 - 17 | Umluftkühlgeräte (erste Klimatisierungsgeräte) |
| 2 | Verbraucherkühlgerät-Ebene (zweite Geräteebene) |
| 21 - 27 | Verbraucherkühlgeräte (zweite Klimatisierungsgeräte) |
| 3 | Kälteerzeuger-Ebene (weitere Geräteebene) |
| 31, 32, 33 | Kälteerzeuger (weitere Klimatisierungsgeräte) |
| 41, 42, 43, 44 | Kaltgänge (Vermittlungsvorrichtungen) |
| 5 | Klimatisierungsmedium |
| 6 | weiteres Klimatisierungsmedium |
| 71 | Kaltgangregelung |
| 72 | Umluftkühlerregelung |
| 73 | Kälteerzeugerregelung |
| 74 | Verbraucherregelung |
| 80 | unterste Schutzebene |
| 81 | erste Schutzebene |
| 82 | zweite Schutzebene |
| 83 | dritte Schutzebene |
| 84 | vierte Schutzebene |
| 85 | fünfte Schutzebene |

**Patentansprüche**

1. Regelungsverfahren für ein Klimatisierungssystem mit zumindest einem ersten Klimatisierungsgerät (11), und zumindest einem zweiten Klimatisierungsgerät (21), wobei zwischen dem ersten Klimatisierungsgerät (11) und dem zweiten Klimatisierungsgerät (21) eine thermische Beeinflussung mittels eines Klimatisierungsmediums (5) erfolgt, **dadurch gekennzeichnet, dass** mittels eines Regelungsalgorithmus ein Gesamtenergiebedarf minimiert wird, welcher als Summe eines Energiebedarfs des ersten Klimatisierungsgerätes (11) und eines Energiebedarfs des zweiten Klimatisierungsgerätes (21) gebildet wird, indem erste Einstellgrößen des ersten Klimatisierungsgerätes (11) und zweite Einstellgrößen des zweiten Klimatisierungsgerätes (21) gesteuert werden.

2. Regelungsverfahren nach Anspruch 1, **dadurch gekennzeichnet, dass** die thermische Beeinflussung einen Austausch des Klimatisierungsmediums (5) zwischen dem ersten Klimatisierungsgerät (11) und dem zweiten Klimatisierungsgerät (21) umfasst.

3. Regelungsverfahren nach Anspruch 1 oder 2, **dadurch gekennzeichnet, dass** das erste Klimatisierungsgerät (11) in einem Satz erster Klimatisierungsgeräte (11, 12, ...) funktional zu einer ersten Geräteebene (1) zusammengefasst ist und dass das zweite Klimatisierungsgerät (21) in einem Satz zweiter Klimatisierungsgeräte (21, 22, ...) funktional zu einer zweiten Geräteebene (2) zusammengefasst ist, wobei zwischen den ersten Klimatisierungsgeräten (11, 12, ...) der ersten Geräteebene (1) und den zweiten Klimatisierungsgeräten (21, 22, ...) der zweiten Geräteebene (2) die thermische Beeinflussung mittels des Klimatisierungsmediums (5) erfolgt und mittels des Regelungsalgorithmus ein Gesamtenergiebedarf minimiert wird, welcher als Summe eines Energiebedarfs eines der oder aller ersten Klimatisierungsgeräte (11, 12, ...) und eines Energiebedarfs eines der oder aller zweiten Klimatisierungsgeräte (21, 22, ...) gebildet wird, indem erste Einstellgrößen des einen, mehrerer der oder aller ersten Klimatisierungsgeräte (11, 12, ...) und zweite Einstellgrößen des einen, mehrerer der oder aller zweiten Klimatisierungsgeräte (21, 22, ...) gesteuert werden.

4. Regelungsverfahren nach Anspruch 3, **dadurch gekennzeichnet, dass** der Gesamtenergiebedarf, welcher mittels des Regelungsalgorithmus minimiert wird, als Summe einen Gesamtenergiebedarf aller ersten Klimatisierungsgeräte (11, 12, ...) der ersten Geräteebene (1) und / oder einen Gesamtenergiebedarf aller zweiten Klimatisierungsgeräte (21, 22, ...) der zweiten Geräteebene (2) umfasst.

5. Regelungsverfahren nach Anspruch 3 oder 4, **dadurch gekennzeichnet, dass** einem oder mehreren der zweiten Klimatisierungsgeräten (21, 22, ...) der zweiten Geräteebene (2) eines oder mehrere der ersten Klimatisierungsgeräte (11, 12, ...) der ersten Geräteebene (1) derart zugeordnet werden, dass die thermische Beeinflussung mittels des Klimatisierungsmediums im Wesentlichen ausschließlich zwischen dem einen oder den mehreren der zweiten Klimatisierungsgeräte (21, 22, ...) und dem einen oder den mehreren der ersten Klimatisierungsgeräte (11, 12, ...) erfolgt.

6. Regelungsverfahren nach Anspruch 5, **dadurch gekennzeichnet, dass** die Zuordnung der ersten Klimatisierungsgeräte (11, 12, ...) zu den zweiten Klimatisierungsgeräten (21, 22, ...) über mehrere Vermittlungsvorrichtungen (41, 42, ...) erfolgt, welche das Klimatisierungsmedium (5) zwischen den ersten Klimatisierungsgeräten (11, 12, ...) und den zweiten Klimatisierungsgeräten (21, 22, ...) vermitteln, indem einer der Vermittlungsvorrichtungen (41, 42, ...) einem oder mehreren der ersten Klimatisierungsgeräte (11, 12, ...) derart zugeordnet werden, dass die thermische Beeinflussung zwischen dem einen oder den mehreren der ersten Klimatisierungsgeräte (11, 12, ...) und dem einen oder den mehreren der zweiten Klimatisierungsgeräte (21, 22, ...) mittels des Klimatisierungsmediums (5) im Wesentlichen ausschließlich über die eine der Vermittlungsvorrichtungen (41, 42, ...) erfolgt.

7. Regelungsverfahren nach Anspruch 5 oder 6, **dadurch gekennzeichnet, dass** die Zuordnung der ersten Klimatisierungsgeräte (11, 12, ...) zu den zweiten Klimatisierungsgeräten (21, 22, ...) automatisch erfolgt.

8. Regelungsverfahren nach Anspruch 7, **dadurch gekennzeichnet, dass** der Regelungsalgorithmus die Zuordnung der ersten Klimatisierungsgeräte (11, 12, ...) zu den zweiten Klimatisierungsgeräten (21, 22, ...) derart durchführt, dass der Gesamtenergiebedarf minimiert wird.

9. Regelungsverfahren nach einem der Ansprüche 3 bis 8, **dadurch gekennzeichnet, dass** das Klimatisierungssystem zumindest ein oder mehrere weitere Klimatisierungsgeräte (31, 32, 33) umfasst, welche funktional zu einer oder mehreren weiteren Geräteebenen (3) zusammengefasst sind, wobei zwischen den ersten Klimatisierungsgeräten (11, 12, ...) der ersten Geräteebene (1) oder den zweiten Klimatisierungsgeräten (21, 22, ...) der zweiten Geräteebene (2) und den weiteren Klimatisierungsgeräten (31, 32, 33) der weiteren Geräteebene (3) eine thermische Beeinflussung mittels eines oder mehrerer weiterer Klimatisierungsmedien (6) erfolgt und der Gesamtenergiebedarf, welcher mittels des Regelungsalgorithmus minimiert wird, als Summe einen Gesamtenergiebedarf eines oder aller weiteren Klimatisierungsgeräte (31, 32, 33) der einen oder mehreren weiteren Geräteebenen (3) umfasst.

10. Regelungsverfahren nach einem der Ansprüche 3 bis 9, **dadurch gekennzeichnet, dass** mehrere oder alle Klimatisierungsgeräte (11, 12, ...; 21, 22, ...; 31, 32, ...) einer Geräteebene (1; 2; 3) räumlich zusammengefasst in einem oder mehreren Baugruppen untergebracht sind.

11. Regelungsverfahren nach einem der Ansprüche 3 bis 9, **dadurch gekennzeichnet, dass** mehrere oder alle Klimatisierungsgeräte (11, 12, ...; 21, 22, ...; 31, 32, ...) einer Geräteebene (1; 2; 3) räumlich getrennt angeordnet sind.

12. Regelungsverfahren nach einem der vorangehenden Ansprüche, **dadurch gekennzeichnet, dass** als Klimatisierungsmedium (5) und / oder als weiteres Klimatisierungsmedium (6) ein flüssiges und / oder ein gasförmiges Medium verwendet wird.

13. Regelungsverfahren nach einem der vorangehenden Ansprüche, **dadurch gekennzeichnet, dass** die erste, die zweite und / oder die weitere Geräteebene (1; 2; 3) eine Kälteerzeugerebene, eine Umluftkühlgerätebene und / oder eine Verbraucherkühlgerätebene umfassen.

14. Klimatisierungssystem mit zumindest einem ersten Klimatisierungsgerät (11) und zumindest einem zweiten Klimatisierungsgerät (21), welche derart angeordnet und miteinander verbunden sind, dass zwischen dem ersten Klimatisierungsgerät (11) und dem zweiten Klimatisierungsgerät (21) eine thermische Beeinflussung mittels eines Klimatisierungsmediums (5) erfolgt, **gekennzeichnet durch** einen Regelungssystem, welches ausgebildet ist, mittels eines Regelungsalgorithmus ein Gesamtenergiebedarf zu minimieren, welcher als Summe eines Energiebedarfs des ersten Klimatisierungsgerätes (11) und eines Energiebedarfs des zweiten Klimatisierungsgerätes (21) gebildet wird.

**Claims**

1. A control method for a climate control system having at least one first climate control device (11) and at least one second climate control device (21), wherein between the first climate control device (11) and the second climate control device (21) a thermal influence is carried out by means of an climate control medium (5), **characterized in that** a total energy demand which is formed as sum of energy demand of the first climate control device (11) and energy demand of the second climate control device (21) is minimized by means of a control algorithm by regulating first setting parameters of the first climate control device (11) and second setting parameters of the second climate control device (21).

2. The control method according to claim 1, **characterized in that** the thermal influence comprises an exchange of the climate control medium (5) between the first climate control device (11) and the second climate control device (21).

3. The control method according to claim 1 or 2, **characterized in that** the first climate control device (11) in a set of first climate control devices (11, 12, ...) is combined functionally to a first device level (1) and that the second climate control device (21) in a set of second climate control devices (21, 22, ...) is combined functionally to a second device level (2), wherein between the first climate control devices (11, 12, ...) of the first device level (1) and the second climate control devices (21 , 22, ...) of the second device level (2) the thermal influence is carried out by means of the climate control medium (5) and a total energy demand which is formed as sum of energy demand of one of the or all of the first climate control devices (11, 12, ...) and an energy demand of one of the or all of the second climate control devices (21, 22, ...) is minimized by means of the control algorithm by regulating first setting parameters of one of the, several of the or all of the first climate control devices (11, 12, ...) and second setting parameters of one of the, several of the or all of the second climate control devices (21, 22, ...).

4. The control method according to claim 3, **characterized in that** the total energy demand which is minimized by the control algorithm comprises as sum a total energy demand of all of the first climate control devices (11, 12, ...) of the first device level (1) and / or a total energy demand of all of the second climate control devices (21, 22, ...) of the second device level (2).

5. The control method according to claim 3 or 4, **characterized in that** one or more of the first climate control devices (11, 12, ...) of the first device level (1) are assigned to one or more of the second climate control devices (21, 22, ...) of the second device level (2) in such a way that the thermal influence by means of the climate control medium is carried out substantially exclusively between the one or more of the second climate control devices (21, 22, ...) and the one or more of the first climate control devices (11, 12, ...).

6. The control method according to claim 5, **characterized in that** the assignment of the first climate control devices (11, 12, ...) to the second climate control devices (21, 22, ...) is carried out via a plurality of switching devices (41, 42, ...) which interfere the climate control medium (5) between the first climate control devices (11, 12, ...) and the second climate control devices (21, 22, ...) by assigning one of the switching devices (41, 42, ...) to one or more the first climate control devices (11, 12, ....) in such a way that the thermal influence between the one or more of the first climate control devices (11, 12, ...) and the one or more of the second climate control devices (21 , 22, ...) by means of the climate control medium (5) is carried out substantially exclusively via the one of the switching devices (41, 42, ...).

7. The control method according to claim 5 or 6, **characterized in that** the assignment of the first climate control devices (11, 12, ...) to the second climate control devices (21, 22, ...) is carried out automatically.

8. The control method according to claim 7, **characterized in that** the control algorithm performs the assignment of the first climate control devices (11, 12, ...) to the second climate control devices (21, 22, ...) in such a way that the total energy demand is minimized.

9. The control method according to one of claims 3 to 8, **characterized in that** the climate control system comprises at least one or more further climate control devices (31, 32, 33) which are combined functionally to one or more further device levels (3), wherein a thermal influence is carried out by one or more further climate control media (6) between the first climate control devices (11, 12, ...) of the first device level (1) or the second climate control devices (21, 22, ...) of the second device level (2) and the further climate control devices (31, 32, 33) of the further device-level (3) and the total energy demand which is minimizes by means of the control algorithm comprises as sum a total energy demand of one or all of the further climate control devices (31, 32, 33) of the one or more further device levels (3).

10. The control method according to one of claims 3 to 9, **characterized in that** several or all of the climate control devices (11, 12, ... ; 21, 22, ... ; 31, 32, ...) of a device level (1; 2; 3) are housed in one or more modules in a spatially combined manner.

11. The control method according to one of claims 3 to 9, **characterized in that** several or all of the climate control devices (11, 12, ... ; 21, 22, ... ; 31, 32, ...) of a device level (1; 2; 3) are arranged in a spatially separated manner.

12. The control method according to one of the preceding claims, **characterized in that** a liquid and / or gaseous medium is used as a climate control medium (5) and / or as a further climate control medium (6).

13. The control method according to one of the preceding claims, **characterized in that** the first, second and / or the further device level (1; 2; 3) comprises a cold generator level, an air circulation cooling device level and / or a consumer cooling device level.

14. A climate control system having at least a first climate control device (11) and at least one second climate control device (21) which are arranged and connected to each other in such a way that a thermal influence is carried out by means of an climate control medium (5) between the first climate control device (11) and the second climate control device (21), **characterized by** a control system which is configured to minimize by means of a control algorithm a total energy consumption which is formed as sum of an energy demand of the first climate control device (11) and an energy demand of the second climate control device (21).

**Revendications**

1. Un procédé de réglage pour un système de climatisation avec au moins un premier dispositif de climatisation (11) et au moins un second dispositif de climatisation (21), dans lequel une influence thermique au moyen d'un milieu de climatisation (5) est réalisée entre le premier dispositif de climatisation (11) et le second dispositif de climatisation (21), **caractérisé en ce qu'**un besoin total d'énergie qui est formé en somme d'un besoin d'énergie du premier dispositif de climatisation (11) et d'un besoin d'énergie du second dispositif de climatisation (21) est minimisé au moyen d'un algorithme de réglage par commandant des premières valeurs de réglage du premier dispositif de climatisation (11) et des secondes valeurs de réglage du second dispositif de climatisation (21).

2. Le procédé de réglage selon la revendication 1, **caractérisé en ce que** l'influence thermique comprend un échange du milieu de climatisation (5) entre le premier dispositif de climatisation (11) et le second dispositif de climatisation (21).

3. Le procédé de réglage selon la revendication 1 ou 2, **caractérisé en ce que** le premier dispositif de climatisation (11) dans un ensemble de premiers dispositifs de climatisation (11, 12, ...) est groupé fonctionnellement en un premier niveau dispositif (1) et que le second dispositif de climatisation (21) dans un ensemble de seconds dispositifs de climatisation (21, 22, ...) est groupé fonctionnellement en un second niveau dispositif (2), dans lequel l'influence thermique au moyen du milieu de climatisation (5) est réalisée entre les premiers dispositifs de climatisation (11, 12, ...) du premier niveau dispositif (1) et les seconds dispositifs de climatisation (21 , 22, ...) du second niveau dispositif (2) et un besoin total d'énergie qui est formé en somme du besoin d'énergie d'un des ou de tous les premiers dispositifs de climatisation (11, 12 ...) et besoin d'énergie d'un des ou de tous les seconds dispositifs de climatisation (21, 22, ...) est minimisé au moyen de l'algorithme de réglage par commandant des premières valeurs de réglage de l'un des, de plusieurs des ou de tous les premiers dispositifs de climatisation (11, 12, ...) et des secondes valeurs de réglage de l'un des, de plusieurs des ou tous les seconds dispositifs de climatisation (21, 22, ...).

4. Le procédé de réglage selon la revendication 3, **caractérisé en ce que** le besoin total d'énergie qui est minimisé par l'algorithme de réglage comprend en somme un besoin total d'énergie de tous les premiers dispositifs de climatisation (11, 12, ...) du premier niveau dispositif (1) et / ou un besoin total d'énergie de tous les seconds dispositifs de climatisation (21, 22, ...) du second niveau dispositif (2).

5. Le procédé de réglage selon la revendication 3 ou 4, **caractérisé en ce qu'**un ou plusieurs des premiers dispositifs de climatisation (11, 12, ...) du premier niveau dispositif (1) sont attribués à un ou plusieurs des seconds dispositifs de climatisation (21, 22, ...) du second niveau dispositif (2) de sorte que l'influence thermique au moyen du milieu de climatisation est réalisée sensiblement exclusivement entre ce ou ces plusieurs seconds dispositifs de climatisation (21, 22, ...) et ce ou ces plusieurs premiers dispositifs de climatisation (11, 12, ...).

6. Le procédé de réglage selon la revendication 5, **caractérisé en ce que** l'attribution des premiers dispositifs de climatisation (11, 12, ...) aux seconds dispositifs de climatisation (21, 22, ...) est réalisée par une pluralité de dispositifs de commutation (41, 42, ...) qui transmettent le milieu de climatisation (5) entre les premiers dispositifs de climatisation (11, 12, ...) et les seconds dispositifs de climatisation (21, 22, ...) par l'attribution d'un ou plusieurs des premiers dispositifs de climatisation (11, 12, ....) à l'un des dispositifs de commutation (41, 42, ...) de sorte que l'influence thermique entre ce ou ces plusieurs des premiers dispositifs de climatisation (11, 12, ...) et ce ou ces plusieurs des seconds dispositifs de climatisation (21 , 22, ...) au moyen du milieu de climatisation (5) est réalisée sensiblement exclusivement par ce dispositif de commutation (41, 42, ...).

7. Le procédé de réglage selon la revendication 5 ou 6, **caractérisé en ce que** l'attribution des premiers dispositifs de climatisation (11, 12, ...) aux seconds dispositifs de climatisation (21, 22, ...) est réalisée automatiquement.

8. Le procédé de réglage selon la revendication 7, **caractérisé en ce que** l'algorithme de réglage fait l'attribution des premiers dispositifs de climatisation (11, 12, ...) aux seconds dispositifs de climatisation (21, 22, ...) de sorte que le besoin total d'énergie est minimisé.

9. Le procédé de réglage selon l'une des revendications 3 à 8, **caractérisé en ce que** le système de climatisation comprend au moins un ou plusieurs autres dispositifs de climatisation (31, 32, 33) qui sont groupés fonctionnellement à un ou plusieurs autres niveaux dispositif (3), dans lequel une influence thermique est réalisée au moyen d'un ou plusieurs autres milieux de climatisation (6) entre les premiers dispositifs de climatisation (11, 12, ...) du premier niveau dispositif (1) ou les seconds dispositifs de climatisation (21, 22, ...) du second niveau dispositif (2) et les autres dispositifs de climatisation (31, 32, 33) de l'autre niveau dispositif (3) et le besoin total d'énergie qui est minimisé au moyen de l'algorithme de réglage comprend en somme un besoin total d'énergie d'un ou de tous les autres dispositifs de climatisation (31, 32, 33) de ce ou ces plusieurs autres niveaux dispositif (3).

10. Le procédé de réglage selon l'une des revendications 3 à 9, **caractérisé en ce que** plusieurs ou tous les dispositifs de climatisation (11, 12, ... ; 21, 22, ... ; 31, 32, ...) d'un niveau dispositif (1; 2; 3) sont logés dans un ou plusieurs modules en regroupement spatial.

11. Le procédé de réglage selon l'une des revendications 3 à 9, **caractérisé en ce que** plusieurs ou tous les dispositifs de climatisation (11, 12, ... ; 21, 22, ... ; 31, 32, ...) d'un niveau dispositif (1; 2; 3) sont disposés séparément dans l'espace.

**12.** Le procédé de réglage selon l'une des revendications précédentes, **caractérisé en ce qu'**on emploie comme milieu de climatisation (5) et ou comme autre milieu de climatisation (6) un milieu liquide et / ou gazeux.

**13.** Le procédé de réglage selon l'une quelconque des revendications précédentes, **caractérisé en ce que** le premier, le second et / ou l'autre niveau dispositif (1; 2; 3) comprennent un niveau de générateur de froid, un niveau de dispositif de refroidissement par air pulsé et / ou un niveau dispositif consommateur de refroidissement.

**14.** Un système de climatisation avec au moins un premier dispositif de climatisation (11) et au moins un second dispositif de climatisation (21) qui sont disposés et reliés les uns aux autres de sorte qu'une influence thermique est réalisée au moyen d'un milieu de climatisation (5) entre le premier dispositif de climatisation (11) et le second dispositif de climatisation (21), **caractérisé par** un système de réglage qui est configuré à minimiser au moyen d'un algorithme de réglage un besoin total d'énergie qui est formé en somme d'un besoin d'énergie du premier dispositif de climatisation (11) et d'un besoin d'énergie du second dispositif de climatisation (21).

Fig. 1

Fig. 2

EP 2 483 605 B1

EP 2 483 605 B1

Fig. 3

**EP 2 483 605 B1**

Fig. 4

Fig. 5

Fig. 6

EP 2 483 605 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1919271 A2
- US 20060168975 A1
- WO 2008127344 A1
- JP 2003116219 A
- EP 0741269 A2